# EUROPEAN PATENT SPECIFICATION

(11) **EP 0 926 716 B1**
(45) Date of publication and mention of the grant of the patent: **16.07.2003**
(21) Application number: 97122263.3
(22) Date of filing: 17.12.1997
(51) Int. Cl.: H01L 21/311, H01J 37/32, C23C 16/44

(54) **Method of processing a semiconductor substrate**
Verfahren zur Behandlung eines Halbleitersubstrates
Méthode de traitement d'un substrat semi-conducteur

(43) Date of publication of application: 30.06.1999
(73) Proprietor: TOKYO ELECTRON LIMITED, Minato-ku, Tokyo 107-8481 (JP)
(72) Inventor: Hisada, Masahiro, c/o Sumitomo Metal Ind., Ltd., Osaka-shi, Osaka (JP)
(74) Representative: Dallmeyer, Georg, Dipl.-Ing.

(56) References cited:
- EP-A- 0 650 182
- EP-A- 0 732 732
- EP-A- 0 819 780
- PATENT ABSTRACTS OF JAPAN vol. 96, no. 2, 29 February 1996 & JP 07 273086 A (SUMITOMO METAL), 20 October 1995,
- PATENT ABSTRACTS OF JAPAN vol. 96, no. 11, 29 November 1996 & JP 08 186082 A (SUMITOMO METAL), 16 July 1996,
- PATENT ABSTRACTS OF JAPAN vol. 18, no. 336 (E-1568), 24 June 1994 & JP 06 084851 A (MITSUBISHI ELECTRIC), 25 March 1994,

## Description

The present invention relates to a method of processing a semiconductor substrate according to claim 1.

In a plasma processing apparatus, a semiconductor substrate placed in a chamber is processed with plasma, generated using a process gas. It has been known that process characteristics of such a plasma processing apparatus are changed in response to variation of temperature of the inner surface of the chamber. Especially, when carbon fluoride system of process gas is employed as the process gas for etching, the process characteristics are remarkably changed in response to the variation of temperature inside the chamber. The carbon fluoride system of gas may be C₂F₆, C₃F₈, C₄F₈, and the like.

For etching a silicon oxide layer formed on a semiconductor substrate, an etching gas including a high proportion of carbon, such as C₄F₈ is used in order to improve the selectivity between the silicon oxide layer and the under layer. Such a carbon fluoride system gas is dissociated in plasma to create plasma activated species, such as ions and radicals. The silicon oxide layer is etched with the plasma activated species. In etching process, plasma activated species that are not used for etching are exhausted or stuck onto the inside wall of the chamber to create polymers, because of high proportion of carbon and low vapor pressure. The activated species are stuck on the inside wall of the chamber at a speed changing based on the temperature of the wall. When the inside wall of the chamber is high in temperature, the polymers stuck on the wall are eliminated or gasified and go back into the plasma. Thus, the density of the plasma activated species are changed in response to the variation of temperature at the inside wall, and therefore, etching rate and selectivity of the silicon oxide layer are remarkably changed as well.

Accordingly, it is required to keep the inside of the chamber at a high temperature in order to process the substrate accurately using a process gas of which reacted products has low vapor pressure. For example, it is required to keep the inside of the chamber at approximately two hundred degree (°C) when the silicon oxide layer is etched If the chamber is not enough heated, more polymers are stuck onto the inner surface of the chamber and the selectivity of the silicon oxide layer is decreased.

For heating the chamber in advance, for example, plasma is generated in the chamber before starting process of substrates to perform plasma processing accurately and stably. Hereinafter, such a process is called "pre-heating." In such a pre-heating process, it is important to heat the chamber to a predetermined temperature for a short period of time in order to improve the total throughput of processing of semiconductor substrates.

Accordingly, a conventional plasma processing apparatus is described in JP-A- 7 273086, which employs an inner belljar covering the inner surface of the chamber. In the apparatus, the inner belljar is heated with plasma to a predetermined temperature instead heating the chamber itself According to the apparatus, if the inner belljar of aluminum, which has a low specific heat, is employed, the inside of the chamber is heated quickly as compared to heating the chamber itself. In the above mentioned conventional apparatus, an oxygen gas is basically used to perform pre-heating process.

EP-A-732 732 discloses a method of precleaning a silicon wafer to remove a layer of native silicon oxide thereon comprising adding a mixture of argon and oxygen to a plasma etch chamber including a waver to be cleaned mounted on a cathode in said chamber.

EP-A-650 182 discloses a processes for etching silicon oxide while using a fluorocarbon film.

An object of the invention is to provide a method of processing a semiconductor substrate, in which the inside of an inner chamber can be heated to a predetermined temperature in a short period of time.

The object is solved with the feature of claim 1.

In the invention, the inert gas may be Helium (He), and the oxygen gas is preferably contained at 10 to 50 volume % in the mixed gas. More preferably, the oxygen gas is contained at 20 to 40 volume % in the mixed gas.

### BRIEF DESCRIPTION OF THE DRAWINGS

Fig. 1 is a cross-sectional view illustrating a first plasma processing system, used in the invention.
Fig. 2 is a cross-sectional view illustrating a second plasma processing system, used in the invention.
Fig. 3 is a flow chart showing steps of plasma processing.
Fig. 4 is a graph showing variation of temperature of the inside of a chamber relative to time in the plasma processing system of Fig.2.
Fig. 5 is a graph showing variation of time for heating the inside of the chamber to a predetermined temperature (200°C) in the plasma system of Fig.2 and in the prior art.
Fig. 6 is a graph showing the relation between an oxygen percentage in a mixed gas and a period of time for heating the inside of the chamber to a predetermined temperature (200°C), in the plasma processing system of Fig.2.

### DETAILED DISCLOSURE OF THE INVENTION

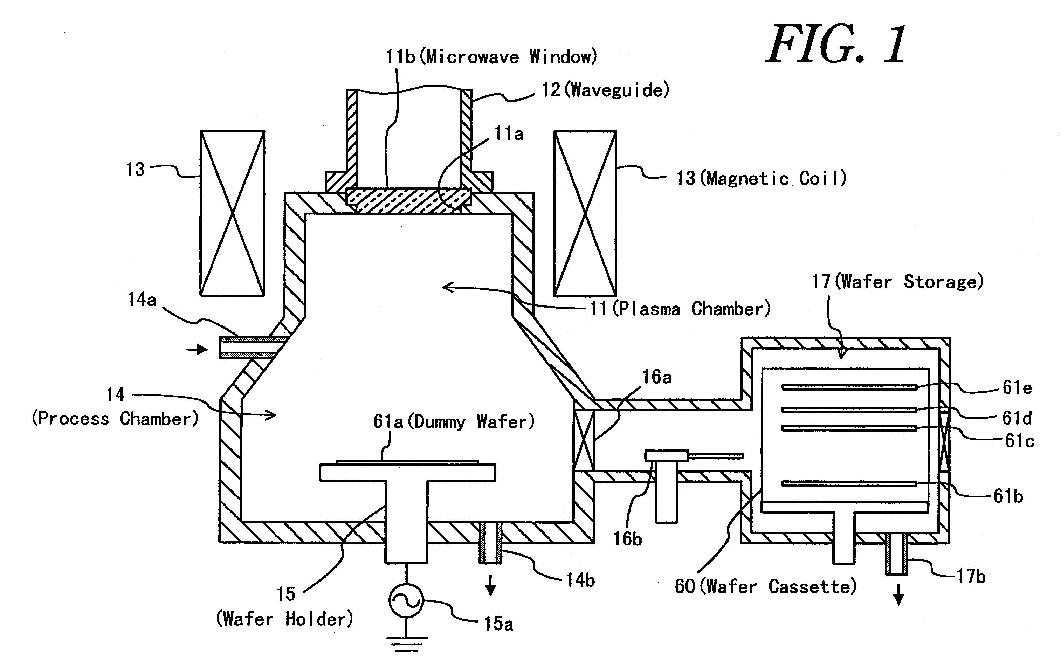

Fig. 1 shows a first plasma processing system, which is designed to process semiconductor wafers with plasma generated using ECR (Electron Cyclotron Resonance). The system includes a waveguide 12 in which a microwave travels, a plasma chamber 11 in which plasma is excited, a process chamber 14 in which a wafer is processed, a magnetic coil 13 and a wafer storage 17. The waveguide 12 is connected to a microwave oscillator (not shown), which generates microwaves of a predetermined frequency and power. The magnetic coil 13 is arranged to surround the plasma chamber 11 on the same axis to provide magnetic field used for exciting plasma therein.

The plasma chamber 11 is provided at a side wall with gas inlets 14a. The process chamber 14 is provided at the bottom with a gas outlet 14b. A mixed gas for pre-heating and a carbon fluoride gas for etching are introduced from the gas inlets 14a into the reaction chamber. The plasma chamber 11 is provided at the top with a microwave introducing opening 11a, which is sealed with a microwave window 11b made of quartz.

In the process chamber 14, a wafer to be processed is placed on a wafer holder 15. The wafer holder 15 is provided with a cooling mechanism (not shown) and an RF electrode (not shown), which is supplied with an RF from an RF supply 15a. The RF is supplied to the wafer holder 15 during operation so as to control energy of ions attack the wafer.

The wafer storage 17 contains a wafer cassette 60 which storing a plurality of wafers 61b-61e to be processed. The wafer storage 17 is provided at the bottom with an exhaust opening 17b, and at the reaction chamber side with a gate valve 16a. The gate valve 16a opens when the wafers 61b-61e are carried into the process chamber 14, and closes in the other case. The wafers 61b-61e are carried by a robot 16b onto the wafer holder 15 when being processed, and back to the wafer cassette 60 when the process thereof is finished. Before the wafers 61b-61e are carried into the process chamber 14, the air in the wafer storage 17 is exhausted from the exhaust opening 17b to regulate the pressure therein so that the pressure in the wafer storage 17 becomes the same as that in the process chamber 14.

Next, operation of the above described plasma processing system is now described. The operation of the system can be divided into two modes of pre-heating and normal etching. In the pre-heating mode, the inside pressure of the plasma chamber 11 and process chamber 14 is reduced by a vacuum system (not shown) to a predetermined pressure. Then, a dummy substrate (silicon wafer) 61a is loaded into the process chamber 14 by the robot 16b. The dummy substrate 61a is held on the wafer holder 15,which has been cooled to a predetermined temperature in advance.

Next, a mixed gas of oxygen and inert gas is introduced from the gas inlet 14a into the plasma chamber 11. The proportions of the oxygen and the inert gas in the mixed gas will be described later. When the plasma chamber 11 is filled with the mixed gas of a predetermined pressure, the magnetic coil 13 is supplied with a direct current to generate a magnetic field for ECR excitation in the plasma chamber 11. When a microwave is supplied from the microwave oscillator (not shown) through the waveguide 12 into the plasma chamber 11, ECR is exited with inter-reaction of the microwave and the magnetic field, and the mixed gas is energized to a plasma state. As a result, the plasma chamber 11 and the process chamber 14 are heated to a predetermined temperature, for example, 200°C. When the temperature of the plasma chamber 11 reaches 200°C, the microwave oscillator and the magnetic coil 13 is turned off to stop the excitation of plasma so that the pre-heating operation will be end.

Next, the remaining gas in the plasma chamber 11 and the process chamber 14 is taken out from the gas outlet 14b, and the dummy substrate 61a is unloaded from the process chamber 14. Instead, a normal substrate (61b) is loaded into the process chamber 14 and is held on the wafer holder 15.

When the normal substrate 61b has been loaded, a process gas including a carbon fluoride system gas, such as C₄F₈ is introduced from the gas inlet 14a into the plasma chamber 11. When the plasma chamber 11 is filled with the process gas of a predetermined pressure, the magnetic coil 13 is supplied with a direct current to generate a magnetic field for ECR excitation in the plasma chamber 11. When a microwave is supplied from the microwave oscillator (not shown) through the waveguide 12 into the plasma chamber 11, ECR is exited with inter-reaction of the microwave and the magnetic field, and the process gas is energized to a plasma state.

After generation of the plasma, the RF supply 15a applies an RF power to the wafer holder 15. Activated species in the plasma, such as ions and radicals, are led to the surface of the substrate 61b so that a silicon oxide layer on the substrate 61b is etched. When the etching process is finished, the microwave oscillator and other devices are turned off After that, the other substrates (silicon wafers) 61c-61e are successively processed in the same manner as that for the substrate 61b.

According to the invention, the plasma chamber 11 is pre-heated with plasma using the mixed gas of oxygen and inert gas, so that the plasma chamber 11 can be heated to a predetermined temperature (200°C) in a short period of time, as compared to using only a single gas, such as oxygen.

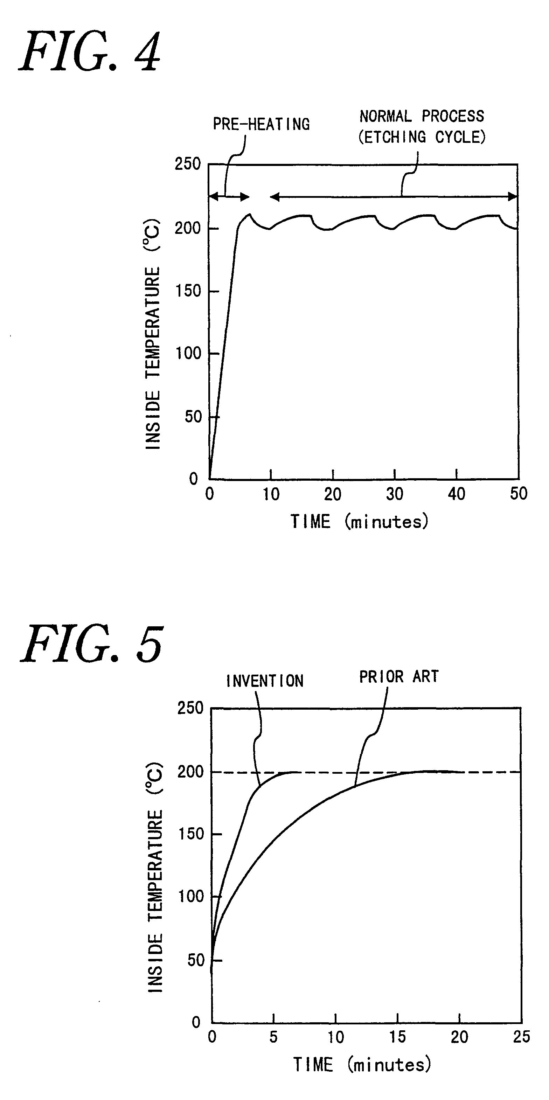

In the invention, the above described inert gas may be helium (He), argon (Ar), neon (Ne), xenon (Xe), and the like. Preferably, helium (He) is employed, because helium activates oxygen in plasma efficiently. When helium (He) is selected as the inert gas to be mixed with oxygen, the oxygen is preferably contained 10 to 50 volume %, and more preferably 20 to 40 volume %, in the mixed gas, so that the efficiency of pre-heating process is remarkably improved. This phenomenon is shown in Fig. 5, which is described later.

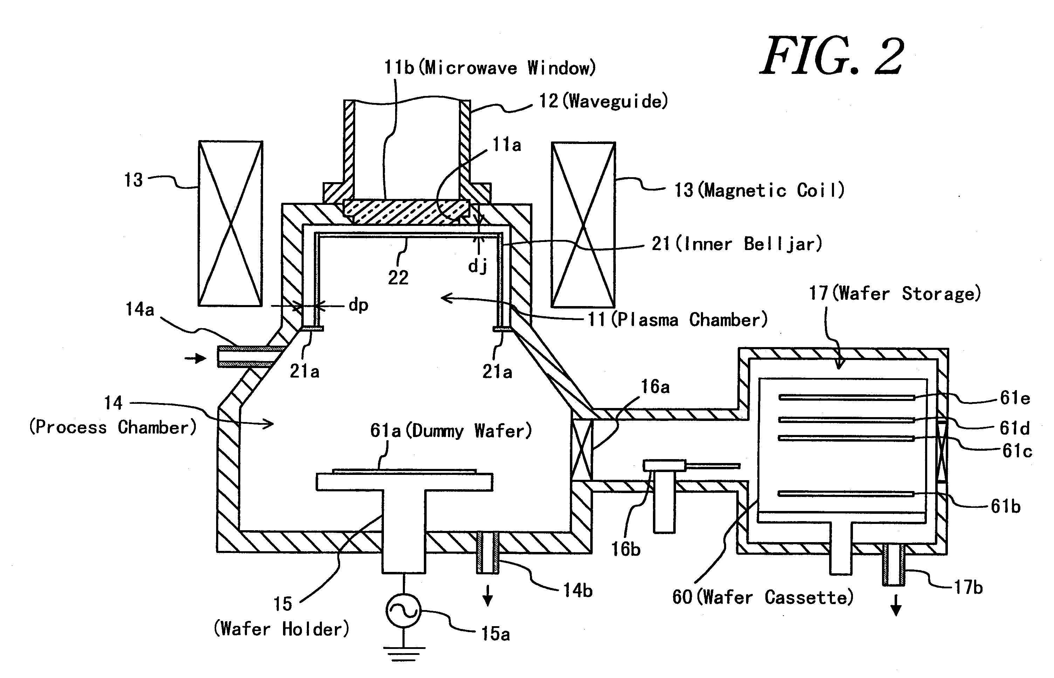

Fig. 2 shows a second plasma processing system, for carrying out the invention, which is designed to process semiconductor wafers using plasma excited with ECR (Electron Cyclotron Resonance). In the second system, the same or corresponding components to the first system, shown in Fig. 1, are represented by the same symbols. And, the same description is not repeated here to avoid redundant description. Basically, the difference between the first and second plasma processing systems is that the second system is provided with an inner belljar (21) in the plasma chamber 11. The inner belljar (21) is provided to improve the throughput of plasma processing as compared to the first plasma processing system. That is, the inside of the plasma chamber 11 and the process chamber 14 can be pre-heated more quickly.

The plasma chamber 11 is provided with above mentioned inner belljar 21, which is shaped cylindrical. The inner belljar 21 is arranged to cover the inside wall of the plasma chamber 11 and to have a space of "dp" to the inner surface of the plasma chamber 11. The inner belljar 21 is fixed by a bracket 21a to the plasma chamber 11. The inner belljar 21 is, for example, made of high purity (more than 99%) aluminum, which has a low heat capacity. Aluminum does not react very much with activated species of carbon fluoride as compared to quartz, therefore, the etching rate can be kept high in this system.

The inner belljar 21 is provided at the top with a microwave transmission plate 22 so that a microwave can be introduced into the plasma chamber 11. The microwave transmission plate 22 is made of silicon nitride (Si₃N₄), or the like, which does not react very much with activated species of carbon fluoride as compared to quartz. Therefore, the etching rate of the processed wafer can be kept high in this system. The microwave transmission plate 22 is shaped to be a circle and is arranged to have a space of "dj" to the inner surface of the plasma chamber 11. The microwave transmission plate 22 is designed to prevent the inner surface of the plasma chamber 11 from being exposed to a plasma.

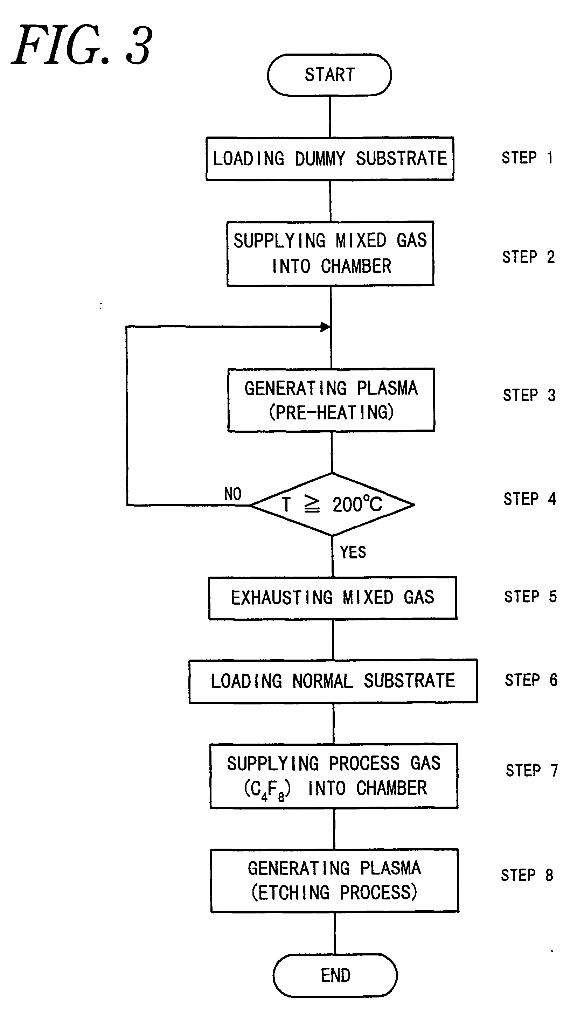

Next, operation of the above described plasma processing system is now described with reference to a flow chart shown in Fig. 3. The operation of this system can be divided into two modes of pre-heating and normal etching. In the pre-heating mode, first, the inside pressure of the plasma chamber 11 and the process chamber 14 is reduced by a vacuum system (not shown) to a predetermined level. Then, in Step 1, a dummy substrate (silicon wafer) 61a is loaded into the process chamber 12 by the robot 16b. The dummy substrate 61a is held on the wafer holder 15,which has been cooled to a predetermined temperature in advance.

In Step 2, a mixed gas of oxygen and inert gas is introduced from the gas inlet 14a into the plasma chamber 11 (inner belljar 21). The proportions of the oxygen and the inert gas in the mixed gas will be described later.

In Step 3, when the plasma chamber 11 (inner belljar 21) is filled with the mixed gas of a predetermined pressure, the magnetic coil 13 is supplied with a direct current to generate a magnetic field for ECR excitation in the plasma chamber 11. When a microwave is supplied from the microwave oscillator (not shown) through the waveguide 12 into the plasma chamber 11, ECR is exited with inter-reaction of the microwave and the magnetic field, and the mixed gas is energized to a plasma state. As a result, the inner belljar 21 is heated to a predetermined temperature, for example, 200°C.

In Step 4, if the temperature of the inner belljar 21 does not reach 200°C, the inner belljar 21 keeps being heated. If the temperature of the inner belljar 21 reaches 200°C, the microwave oscillator and the magnetic coil are turned off to stop the excitation of plasma so that the pre-heating operation will be end.

In Step 5, the remaining gas in the plasma chamber 11 and the process chamber 14 is taken out from the gas outlet 14b.

In Step 6, the dummy substrate 61a is unloaded from the process chamber 14, and instead, a normal substrate (61b) is loaded into the process chamber 14 and is held on the wafer holder 15.

In Step 7, a process gas including a carbon fluoride system gas, such as C₄F₈ is introduced from the gas inlet 14a into the plasma chamber 11 so that the plasma chamber 11 (inner belljar 21) is filled with the process gas of a predetermined pressure.

In Step 8, the magnetic coil 13 is supplied with a direct current to generate a magnetic field for ECR excitation in the plasma chamber 11. When a microwave is supplied from the microwave oscillator (not shown) through the waveguide 12 into the plasma chamber 11, ECR is exited with inter-reaction of the microwave and the magnetic field, and the process gas is energized to a plasma state. After generation of the plasma, the RF supply 15a applies an RF power to the wafer holder 15. Activated species in the plasma, such as ions and radicals, are led to the surface of the substrate 61b so that a silicon oxide layer on the substrate 61b is etched. When the etching process is finished, the microwave oscillator and other devices are turned off to end up the etching process. After that, the other substrates (silicon wafers) 61c-61e are processed successively in the same manner as that for the substrate 61b.

According to the invention, the inner belljar 21 is pre-heated with plasma using the mixed gas of oxygen and inert gas, so that the inner belljar 21 can be heated to a predetermined temperature (200°C) in a short period of time, which is shorter than in the first system.

Fig. 4 shows the variation of temperature of the inner belljar 21, in the second system. At the beginning of the pre-heating mode, the temperature of the inner belljar 21 is increased rapidly to slightly higher than 200°C. Then the temperature of the inner belljar 21 goes down, when the dummy substrate 61a is changed. In this invention, an interval of the etching process and a period of time for the pre-heating process are well controlled so as to keep the temperature of the inner belljar 21 at an optimum level and range, such as 200±10°C.

### [Test of Performance]

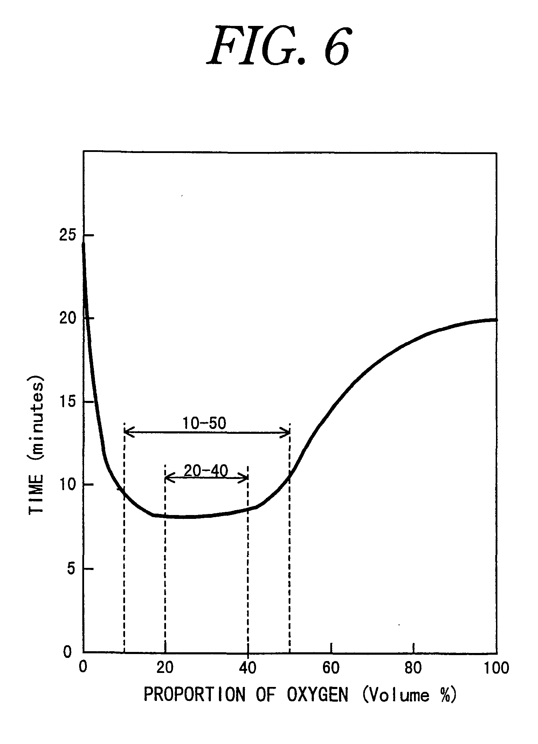

Next, the performance of the second plasma processing system is described in conjunction with the graphs shown in Figs. 5 and 6. In the test, the ECR plasma processing system shown in Fig. 2 is used. It is assumed that the plasma chamber 11 is designed to have an inside diameter of 270 mm. The inner belljar 21 is made of high purity (more than 99%) of aluminum and is shaped cylindrical having a thickness of about 8 mm. The spacing "dp" between the inner belljar 21 and the plasma chamber 11 is about 1 mm. The microwave transmission plate 22 is made of silicon nitride and have a thickness of 5 mm. The spacing "dj" between the microwave transmission plate 22 and the plasma chamber 11 is about 3 mm. Microwaves to be introduced into the plasma chamber 11 has a frequency of 2.45 GHz. The wafer holder 15 is applied with an RF of 400 kHz.

In the pre-heating mode, a mixed gas of oxygen and helium is used, and the temperature of the inner belljar 21 is measured with a thermocouple (not shown). The oxygen gas and helium gas are supplied at flowing rates of 10 sccm and 40 sccm, respectively. The plasma chamber 11 and the process chamber 14 are controlled in pressure at 1 mTorr, and is supplied with 1.5 kW of microwave.

Fig. 5 shows how many minutes are required to heat the inner belljar 21 to 200 °C in accordance with the invention and with conventional art. As shown in the graph of Fig. 5, the invention only needs about seven minutes, while the prior art needs about twenty minutes.

Fig. 6 shows the variation of time for pre-heating the inner belljar to 200°C relative to the proportion (volume %) of oxygen in the mixed gas. When a single gas of helium (oxygen percentage is zero) is used for pre-heating the inner belljar 21, it takes about twenty-five minutes to heat it to 200°C, which is little longer than the case where 100% oxygen gas is used. The time is shortened when the oxygen percentage is increased, and it becomes under ten minutes when the oxygen percentage gets to ten percent, which is less than half of prior art. However, when the oxygen percentage gets over fifty percent, the time gets longer again. As can be understood from the graph in Fig. 6, the proportion of oxygen in the mixed gas is preferably determined in the range between ten percent and fifty percent, more preferably twenty percent and forty percent.

As described before, according to the invention, the time (period of time) for pre-heating process is remarkably shortened as compared to the conventional technology, and therefore, the total throughput of the plasma processing can be improved (shortened).

The invention is not limited by etching process of a silicon oxide layer using carbon fluoride gas, that is, the invention is applicable to other type of plasma processing. However, the invention is useful to the above mentioned embodiment, in which the silicon oxide layer is etched with plasma exited with carbon fluoride gas. The carbon fluoride gas may be, CF₄, C₂F₆, C₃F₈,C₄F₈, and the like. Further, the invention can be applied to other types of plasma processing system in addition to the above described ECR plasma type.

## Claims

1. A method of processing a semiconductor substrate (61b,61c,61d,61e) placed in a chamber (14) comprising the steps of:
- loading a dummy substrate (61a) into the chamber (14),
- supplying a mixed gas into said chamber (14),
- generating a plasma with the mixed gas in said chamber so as to heat the inside of the chamber (14) to a predetermined temperature,
- turning off the plasma and exhausting the mixed gas outside said chamber (14) when the inside of the chamber (14) has reached said predetermined temperature,
- unloading the dummy substrate (61a) from said chamber (14) and loading a semiconductor substrate (61b,61c,61d,61e) to be etched in said chamber (14),
- supplying a process gas into said chamber (14), said process gas including a carbon fluoride gas,
- generating a plasma in said chamber (14) to etch the semiconductor substrate (61b,61c,61d,61e) **characterized in that** the mixed gas used to heat the inside of the chamber (14) is a mixture of oxygen and inert gas.

2. The method according to claim 1 , wherein
the inert gas is one selected from Helium (He), Argon (Ar), Neon (Ne) and Xenon (Xe).

3. The method according to claim 1 or 2, wherein
the inert gas is Helium (He), and
10 to 50 volume % of the oxygen gas is contained in the mixed gas.

4. The method according to one of the claims 1 to 3, wherein
20 to 40 volume % of the oxygen gas is contained in the mixed gas.

## Patentansprüche

1. Verfahren zum Bearbeiten eines in einer Kammer (14) angeordneten Halbleitersubstrats (61b, 61c, 61d, 61e) mit den folgenden Schritten:
- Laden eines Leersubstrats (61a) in die Kammer (14),
- Leiten eines Gasgemischs in die Kammer (14),
- Erzeugen eines Plasmas mit dem Gasgemisch in der Kammer, um das Innere der Kammer (14) auf eine vorbestimmte Temperatur zu erwärmen,
- Abschalten des Plasmas und Ablassen des Gasgemischs aus der Kammer (14), wenn das Innere der Kammer (14) die vorbestimmte Temperatur erreicht hat,
- Entnehmen des Leersubstrats (61a) aus der Kammer (14) und Laden eines zu ätzenden Halbleitersubstrats (61b, 61c, 61d, 61e) in die Kammer (14),
- Leiten eines Prozessgases in die Kammer (14), wobei das Prozessgas ein Fluorkohlenstoffgas enthält,
- Erzeugen eines Plasmas in der Kammer (14), um das Halbleitersubstrat (61b, 61c, 61d, 61e) zu ätzen,
**dadurch gekennzeichnet, daß**
- das zum Erwärmen des Inneren der Kammer (14) verwendete Gasgemisch eine Mischung aus Sauerstoff und Inertgas ist.

2. Verfahren nach Anspruch 1, bei dem das Inertgas unter Helium (He), Argon (Ar), Neon (Ne) und Xenon (Xe) ausgewählt ist.

3. Verfahren nach Anspruch 1 oder 2, bei dem das Inertgas Helium (He) ist, und 10 bis 50 Volumenprozent des Sauerstoffs in dem Gasgemisch enthalten sind.

4. Verfahren nach einem der Ansprüche 1 bis 3, bei dem 20 bis 40 Volumenprozent des Sauerstoffs im Gasgemisch enthalten sind.

## Revendications

1. Méthode de traitement d'un substrat semi-conducteur (61b, 61c, 61d, 61e) placé dans une chambre (14), comprenant les étapes consistant à :
- charger un pseudo-substrat (61a) dans la chambre (14),
- alimenter ladite chambre (14) en gaz mixte,
- générer un plasma avec le gaz mixte dans ladite chambre afin de chauffer l'intérieur de la chambre (14) à une température prédéterminée,
- faire cesser le plasma et faire sortir le gaz mixte de ladite chambre (14) lorsque l'intérieur de la chambre (14) a atteint ladite température prédéterminée,
- décharger le pseudo-substrat (61a) de ladite chambre (14) et charger dans ladite chambre (14) un substrat semi-conducteur (61b, 61c, 61d, 61e) qui doit être gravé
- alimenter en un gaz de traitement ladite chambre (14), ledit gaz de traitement comprenant un gaz de fluorure de carbone,
- générer un plasma dans ladite chambre (14) pour graver le substrat semi-conducteur (61b, 61c, 61d, 61e),
**caractérisée en ce que** le gaz mixte utilisé pour chauffer l'intérieur de la chambre (14) est un mélange d'oxygène et de gaz inerte.

2. Méthode selon la revendication 1, dans laquelle le gaz inerte est un gaz choisi parmi l'hélium (He), l'argon (Ar), le néon (Ne) et le xénon (Xe).

3. Méthode selon la revendication 1 ou 2, dans laquelle le gaz inerte est l'hélium (He), et le gaz mixte contient de 10 à 50 % en volume d'oxygène gazeux.

4. Méthode selon l'une des revendications 1 à 3, dans laquelle 20 à 40 % en volume d'oxygène gazeux est contenu dans le gaz mixte.
